# EUROPÄISCHE PATENTANMELDUNG

(11) **EP 2 565 875 A1**
(43) Veröffentlichungstag der Anmeldung: **06.03.2013**
(21) Anmeldenummer: 11179409.5
(22) Anmeldetag: 30.08.2011
(51) Int. Cl.: G11C 5/14

(54) **Verfahren zum Betreiben eines elektrischen Gerätes**

(71) Anmelder: SIEMENS AKTIENGESELLSCHAFT, 80333 München (DE)
(72) Erfinder: Neubert, Axel, 76275 Ettlingen (DE); Spuhler, Bernhard, 76877 Offenbach (DE)

(57) **Zusammenfassung**

Die Erfindung betrifft ein Verfahren zum Betreiben eines elektrischen Gerätes (1), das ein CPU-Modul (2) und einen Massenspeicher (4) aufweist, welcher mit einer Versorgungsspannung beaufschlagt wird und welchem über eine Leitung (5) Daten seriell übertragen werden, wobei mittels einer dem Massenspeicher (4) zugeführten Befehlssequenz der Massenspeicher (4) in einen sicheren Zustand gesetzt wird. Es werden Maßnahmen vorgeschlagen, mittels deren bei einem Spannungsausfall ein Datenverlust vermieden wird.

## Beschreibung

Die Erfindung betrifft ein Verfahren zum Betreiben eines elektrischen Gerätes, das ein CPU-Modul und einen Massenspeicher aufweist, welcher mit einer Versorgungsspannung beaufschlagt wird und welchem über eine Leitung Daten seriell übertragen werden, wobei mittels einer dem Massenspeicher zugeführten Befehlssequenz des CPU-Moduls der Massenspeicher in einen sicheren Zustand gesetzt wird. Darüber hinaus betrifft die Erfindung ein elektrisches Gerät, welches zur Durchführung des Verfahrens geeignet ist.

In zunehmendem Maße werden in so genannten z. B. aus dem Siemens-Katalog ST 80/ST PC, Kapitel 5, Ausgabe 2011 bekannten Industrie Personal Computern (Industrie-PCs) Massenspeicher eingesetzt, die mit einer seriellen Schnittstelle zur Übertragung eines seriellen Protokolls versehen sind. Für den Fall, dass ein derartiger z. B. mit einer SATA- oder SAS-Schnittstelle versehener Massenspeicher nicht ausreichend mit einer geeigneten Spannung versorgt wird, beispielsweise aufgrund eines unvorhergesehenen Spannungsausfalls oder Spannungseinbruchs, können abzuspeichernde Daten verloren gehen.

Um einen Datenverlust zu vermeiden, kann eine unterbrechungsfreie Stromversorgung (USV) eingesetzt werden, die für eine bestimmte Zeitspanne bzw. ein vorgegebenes Zeitintervall die Versorgung des Gerätes mit einer geeigneten Spannung aufrechterhält. Während dieser Zeitspanne übermittelt ein CPU-Modul des Gerätes einem Controller des Massenspeichers eine Befehlssequenz, aufgrund deren der Massenspeicher in einen sicheren Zustand gesetzt wird, wobei die noch zu sichernden Daten abgespeichert werden. Nachteilig ist, dass der Einsatz einer unterbrechungsfreien Stromversorgung kosten- und ferner wartungsintensiv ist. Darüber hinaus ist es in vielen Fällen aus Platzgründen nicht möglich, in das Gerät eine derartige Stromversorgung einzubauen.

Der Erfindung liegt daher die Aufgabe zugrunde, ein Verfahren der eingangs genannten Art anzugeben, welches in einer vereinfachten Art und Weise bei einem Spannungsausfall einen Datenverlust vermeidet. Darüber hinaus ist ein elektrisches Gerät zu schaffen, welches zur Durchführung des Verfahrens geeignet ist.

Diese Aufgabe wird im Hinblick auf das Verfahren durch die im kennzeichnenden Teil des Anspruchs 1, bezüglich des elektrischen Gerätes durch die im kennzeichnenden Teil des Anspruchs 3 angegebenen Maßnahmen gelöst.

Die Erfindung geht von der Idee aus, die an sich bekannten und ohnehin vorgesehenen Befehlssequenzen zum Überführen bzw. Setzen des Massenspeichers in einen sicheren Zustand auch bei einem Spannungsausfall oder Spannungseinbruch zu nutzen.

Die Überwachungseinheit ist als "trennendes" Bindeglied zwischen dem Massenspeicher, beispielsweise Festplattenlaufwerk (HDD) oder Solid-State-Disk (SSD), und dem CPU-Modul des Gerätes bzw. Industrie-PCs vorgesehen. Im Falle eines Spannungsausfalls "trennt" das Überwachungs-Modul den Massenspeicher von dem CPU-Modul und überführt den Massenspeicher in einen sicheren Zustand bzw. Ruhezustand, unabhängig von einem durch Spannungsstörungen typischerweise unkontrollierten Verhalten des CPU-Moduls.

Der Massenspeicher wird nicht unkontrolliert abgeschaltet, sondern dessen Betrieb zunächst geordnet beendet, d. h., der Massenspeicher wird erst dann abgeschaltet, wenn zuvor die Daten gesichert sind; ein Verlust oder eine Verfälschung von Daten sowie die Erzeugung von Fehlerzuständen wird somit vermieden. Für dieses geordnete Abschalten wird - wie erläutert - die dazu ohnehin vorgesehene Befehlssequenz bzw. der dazu vorgesehene Protokollablauf verwendet, wobei die Überwachungseinheit diese Befehlssequenz bzw. dieses serielle Protokoll erzeugt und dem Massenspeicher übermittelt. Mit anderen Worten: der für den Massenspeicher "passende" Protokollablauf wird von dem Überwachungs-Modul selbständig in der Weise abgewickelt, dass noch ausstehende Speicheraufträge abgeschlossen werden und der Massenspeicher in einen sicheren Ruhezustand übergeht, wobei Daten weder verfälscht noch verloren gehen und keine Fehlerzustände bewirkt werden.

Vorteilhaft ist, dass auf eine wartungsintensive unterbrechungsfreie Stromversorgung verzichtet werden kann, die ferner aufgrund ihrer räumlichen Dimensionierung beispielsweise für einen Einsatz in einem Notebook gewöhnlich nicht geeignet ist. Die Überwachungseinheit belegt lediglich einen Steckplatz in einem Notebook oder Industrie-PC, wobei der Energiespeicher der Überwachungseinheit, z. B. ein Energiespeicher in Form eines Kondensators, im Hinblick auf Platzbedarf und Kapazität sehr klein gewählt werden kann.

In einer Ausgestaltung der Erfindung ist vorgesehen, dass während der Versorgung des Massenspeichers mittels des Energiespeichers eine Kommunikation zwischen dem CPU-Modul und dem Massenspeicher verhindert wird. Störende Kommunikationseinflüsse seitens des CPU-Moduls auf das Überwachungs-Modul zum Bewerkstelligen eines geordneten Abschaltens des Massenspeichers werden dadurch vermieden.

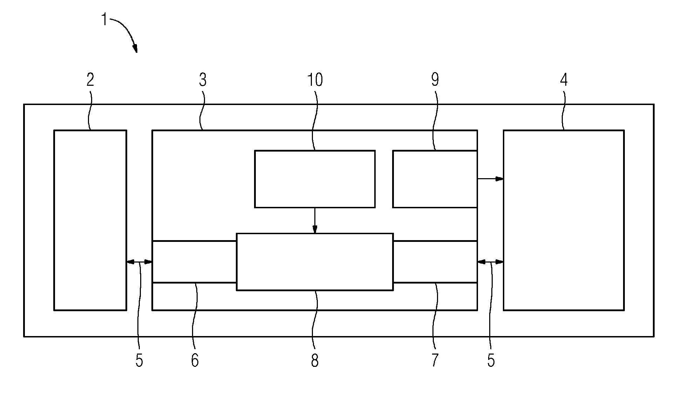

Die Erfindung wird nachfolgend anhand eines Ausführungsbeispiels unter Bezugnahme auf die einzige Figur der Zeichnung näher erläutert. Die Figur der Zeichnung zeigt in vereinfachter Form Bestandteile eines elektrischen Gerätes.

In der Figur ist mit 1 eine Systemeinheit eines Industrie-PCs (Industrie Personal Computer) bezeichnet, in welcher ein CPU-Modul 2, ein Überwachungs-Modul 3 und ein Massenspeicher 4 in Form eines Festplattenlaufwerks angeordnet sind. Die Module 2 und 3 sind z. B. als Steckkarten ausgebildet, welche in dazu vorgesehene Steckplätze eines so genannten Motherboards der Systemeinheit 1 gesteckt sind. An diese Systemeinheit 1 sind Bedieneingabe-Einheiten, z. B. Bedieneingabe-Einheiten in Form einer Tastatur und/oder einer Maus, sowie mindestens ein Bildwiedergabegerät und weitere Hardware-Einheiten anschließbar. Selbstverständlich weist das Motherboard weitere Steckplätze zur Aufnahme weiterer Steckkarten auf, z. B. Steckkarten zur Verwirklichung einer Ethernet- oder Feldbuskommunikation. Weitere Bestandteile der Systemeinheit 1, wie beispielsweise ein Netzteil oder sonstige für den Betrieb des Industrie-PCs geeignete Hardwaremittel, sind für die Erfindung ohne Bedeutung und werden daher nicht erläutert.

Eine Datenleitung 5 ist für eine serielle Datenübertragung bzw. zur Übertragung eines seriellen Protokolls zwischen dem CPU-Modul 2 und dem Massenspeicher 4 vorgesehen, wobei das Überwachungs-Modul 3 zwischen das CPU-Modul 2 und den Massenspeicher 4 geschaltet ist. Unter dem Begriff "Datenübertragung" wird in diesem Zusammenhang selbstverständlich auch die Übertragung von Befehlen oder Anweisungen verstanden.

Sowohl der Massenspeicher 4 als auch das CPU-Modul 2 sowie das Überwachungs-Modul 3 sind mit geeigneten Schnittstellen zum Anschließen an diese Datenleitung 5 versehen. Im vorliegenden Ausführungsbeispiel ist lediglich eine erste und eine zweite serielle Schnittstelle 6, 7 des Überwachungs-Moduls 3 dargestellt, von denen die erste Schnittstelle 6 die Kommunikation zwischen dem CPU-Modul 2 und einer Steuereinheit 8 des Überwachungs-Moduls 3 und die zweite Schnittstelle 7 die Kommunikation zwischen dieser Steuereinheit 8 und dem CPU-Modul 2 abwickelt.

In einer Normalbetriebsart, d. h. in einem störungsfreien Betrieb, verwirklicht die Steuereinheit 8 mit den seriellen Schnittstellen 6, 7 eine "transparente" Verbindung zwischen dem CPU-Modul 2 und dem Massenspeicher 4, was bedeutet, dass in dieser Betriebsart die Steuereinheit 8 die von dem CPU-Modul 2 übermittelten und für den Massenspeicher 4 vorgesehenen Daten direkt dem Massenspeicher 4 zuführt. Beispielsweise wird eine von dem CPU-Modul 2 erzeugte Befehlssequenz dem Massenspeicher 4 übermittelt, aufgrund deren durch geeignete Mittel des Massenspeichers 4, z. B. Mittel in Form eines Controllers, der Massenspeicher 4 in einen sicheren Zustand gefahren bzw. gesetzt wird, wobei dazu die aktuell abzuspeichernden Daten im Massenspeicher 4 hinterlegt bzw. abgespeichert werden und der Massenspeicher 4 schließlich in einen Ruhezustand überführt wird.

Das Überwachungs-Modul 3 weist darüber hinaus einen Energiespeicher 9 und eine Spannungsüberwachungseinheit 10 auf, welche eine hier nicht dargestellte für den Massenspeicher 4 geeignete Versorgungsspannung überwacht, die über eine ebenfalls hier nicht dargestellte Versorgungsleitung dem Massenspeicher 4 zugeführt ist. Der Energiespeicher 9, welcher für den Fall eines Ausfalls oder eines Einbruchs der Versorgungsspannung die Versorgung des Massenspeichers 4 mit einer für den Betrieb des Massenspeichers 4 geeigneten Spannung übernimmt, ist in Form einer Batterie oder eines Akkus ausgebildet. Selbstverständlich kann der Energiespeicher 9 auch als Kondensator ausgestaltet sein, der während eines störungsfreien Betriebs geladen wird, sich während des Ausfalls der Versorgungsspannung entlädt und dadurch die für den Betrieb des Massenspeichers 4 geeignete Spannung für eine Zeitspanne bzw. für ein Zeitintervall bereitstellt.

Es kann vorkommen, dass aufgrund eines Ausfalls oder eines Einbruchs der Versorgungsspannung der Massenspeicher 4 nicht ausreichend mit der für einen störungsfreien Betrieb des Massenspeichers 4 erforderlichen Energie versorgt wird, wodurch es zu einem Verlust von aktuell abzuspeichernden Daten kommen kann. Um eine derartige Störung zu erkennen, überwacht - wie erläutert - die Spannungsüberwachungseinheit 10 die Versorgungsspannung und meldet der Steuereinheit eine Störung, falls die Versorgungsspannung einen Schwellwert erreicht oder unterschreitet.

Im Folgenden wird angenommen, dass die Versorgungsspannung diesen Schwellwert erreicht oder unterschritten hat. Um in diesem Fall einen Datenverlust zu vermeiden, versorgt der Energiespeicher 9 den Massenspeicher 4 mit der für den Betrieb des Massenspeichers 4 erforderlichen Energie und die Steuereinheit 8 erzeugt aufgrund der Meldung der Spannungsüberwachungseinheit 10 den Befehl bzw. die Befehlssequenz zum Setzen bzw. zum Fahren des Massenspeichers 4 in den sicheren Zustand und übermittelt diesen Befehl bzw. diese Befehlssequenz dem Massenspeicher 4. Aufgrund des empfangenen Befehls bzw. der empfangenen Befehlssequenz werden die im Massenspeicher 4 aktuell abzuspeichernden Daten hinterlegt und der Massenspeicher 4 in einen Ruhezustand versetzt.

Damit lässt sich die Erfindung wie folgt zusammenfassen:
Ein Verfahren zum Betreiben eines elektrischen Gerätes 1, das ein CPU-Modul 2 und einen Massenspeicher 4 aufweist, welcher mit einer Versorgungsspannung beaufschlagt wird und welchem über eine Leitung 5 Daten seriell übertragen werden, wobei mittels einer dem Massenspeicher 4 zugeführten Befehlssequenz der Massenspeicher 4 in einen sicheren Zustand gesetzt wird, zeichnet sich dadurch aus, dass mittels einer Spannungsüberwachungseinheit 10 eines Überwachungs-Moduls 3 die Versorgungsspannung überwacht wird, wobei für den Fall, dass die Versorgungsspannung einen Schwellwert erreicht oder unterschreitet, mittels eines Energiespeichers 9 des Überwachungs-Moduls 3 die Versorgung des Massenspeichers 4 übernommen und mittels einer Steuereinheit 8 des Überwachungs-Moduls 3 die Befehlssequenz erzeugt wird. Mittels derartiger Maßnahmen wird bei einem Spannungsausfall oder einem Spannungseinbruch ein Datenverlust vermieden.

## Patentansprüche

1. Verfahren zum Betreiben eines elektrischen Gerätes (1), das ein CPU-Modul (2) und einen Massenspeicher (4) aufweist, welcher mit einer Versorgungsspannung beaufschlagt wird und welchem über eine Leitung (5) Daten seriell übertragen werden, wobei mittels einer dem Massenspeicher (4) zugeführten Befehlssequenz der Massenspeicher (4) in einen sicheren Zustand gesetzt wird, **dadurch gekennzeichnet, dass** mittels einer Spannungsüberwachungseinheit (10) eines Überwachungs-Moduls (3) die Versorgungsspannung überwacht wird, wobei für den Fall, dass die Versorgungsspannung einen Schwellwert erreicht oder unterschreitet, mittels eines Energiespeichers (9) des Überwachungs-Moduls (3) die Versorgung des Massenspeichers (4) übernommen und mittels einer Steuereinheit (8) des Überwachungs-Moduls (3) die Befehlssequenz erzeugt wird.

2. Verfahren nach Anspruch 1, **dadurch gekennzeichnet, dass** während der Versorgung mittels des Energiespeichers (9) eine Kommunikation zwischen dem CPU-Modul (2) und dem Massenspeicher (4) verhindert wird.

3. Elektrisches Gerät mit einem CPU-Modul und einem Massenspeicher, welcher versehen ist mit
- einem Anschluss zum Anschließen an eine Versorgungsspannung und einer Schnittstelle zum Anschließen an eine für eine serielle Datenübertragung vorgesehene Datenleitung (5),
- Mitteln, die dazu ausgebildet sind, den Massenspeicher (4) mittels einer dem Massenspeicher über die Datenleitung (5) zugeführten Befehlssequenz in einen definierten Zustand zu setzen,
**dadurch gekennzeichnet, dass** zwischen dem CPU-Modul (2) und dem Massenspeicher (4) ein Überwachungs-Modul (3) geschaltet ist, welches dazu ausgebildet ist, mittels einer Spannungsüberwachungseinheit (10) die Versorgungsspannung zu überwachen und für den Fall, dass die Versorgungsspannung einen Schwellwert erreicht oder unterschreitet, mittels eines Energiespeichers (9) die Versorgung des Massenspeichers (4) zu übernehmen und mittels einer Steuereinheit (8) die Befehlssequenz zu erzeugen.

4. Elektrisches Gerät nach Anspruch 3, **dadurch gekennzeichnet, dass** das Überwachungs-Modul (3) ferner dazu ausgebildet ist, während der Versorgung des Massenspeichers (4) mittels eines Energiespeichers (9) des Überwachungs-Moduls (3) eine Kommunikation zwischen dem CPU-Modul (2) und dem Massenspeicher (4) zu verhindern.
